Europäisches Patentamt

European Patent Office

Office européen des brevets

(11) Numéro de publication: **0 267 862**
**A1**

# (12) DEMANDE DE BREVET EUROPEEN

(21) Numéro de dépôt: 87440071.6

(22) Date de dépôt: 27.10.87

(51) Int. Cl.⁴: **H 05 K 1/09**
C 22 F 1/00, C 04 B 37/02,
C 03 C 27/04

(30) Priorité: 28.10.86 FR 8615101

(43) Date de publication de la demande:
**18.05.88 Bulletin 88/20**

(84) Etats contractants désignés: **DE FR GB**

(71) Demandeur: **CIMULEC**
**Z.I. Route de Metz Ennery**
**F-57640 Vigy (FR)**

(84) Etats contractants désignés: **DE GB**

(71) Demandeur: **CENTRE NATIONAL DE LA RECHERCHE**
**SCIENTIFIQUE (CNRS)**
**15, Quai Anatole France**
**F-75700 Paris (FR)**

(84) Etats contractants désignés: **FR**

(72) Inventeur: **Eberhardt, André**
**20 rue du Professeur Oberling**
**F-57000 Metz (FR)**

**Dominiak, Serge**
**1 chemin du Carcan**
**Vaux F-57130 Ars Sur Moselle (FR)**

**Berveiler, Marcel**
**15 rue de la Chavée**
**F-57140 Woippy (FR)**

**Lucas, Jean Pierre**
**39 rue du Général Dalstein**
**F-57000 Metz (FR)**

**Guyon, Pierre Yves Robert**
**6 rue du Château Ennery**
**F-57640 Vigy (FR)**

(74) Mandataire: **Nuss, Pierre**
**10, rue Jacques Kablé**
**F-67000 Strasbourg (FR)**

(54) **Elément de compensation de contraintes d'origine thermique ou mécanique, notamment pour circuit imprimé, et procédé de fabrication d'un tel élément mis en oeuvre dans un circuit imprimé.**

(57) Elément de compensation caractérisé en ce qu'il est constitué partiellement ou complètement d'un alliage pseudoélastique ou à mémoire de forme subissant de façon réversible des déformations importantes, même sous de très faibles contraintes et utilisé notamment dans les circuits imprimés.

EP 0 267 862 A1

Bundesdruckerei Berlin

## Description

**Elément de compensation de contraintes d'origine thermique ou mécanique, notamment pour circuit imprimé, et procédé de fabrication d'un tel élément mis en oeuvre dans un circuit imprimé**

La présente invention concerne un élément de compensation de contraintes d'origine thermique ou mécanique, notamment pour circuit imprimé, et un procédé de fabrication d'un tel élément mis en oeuvre dans un circuit imprimé.

La différence des coefficients de dilatation thermique des constituants d'un assemblage est à l'origine de contraintes mécaniques dont l'ampleur peut entraîner la détérioration de l'assemblage. Les solutions actuellement envisagées pour améliorer les performances des assemblages sont principalement de deux types :
- soit on adapte les coefficients de dilatation de telle sorte que la dilatation différentielle soit faible,
- soit on interpose entre les parties de l'assemblage une pièce intermédiaire déformable de façon réversible.

A titre d'exemple, les circuits imprimés sont constitués, quant à eux, d'un support isolant et de couches conductrices en cuivre qui constituent l'ensemble des connections dont au moins l'une est située sur l'une des faces externes du support et permet la soudure des composants. Ce support isolant est en matériau organique, habituellement en fibre de verre - résine époxyde ou en fibre de verre polyimide, dont le coefficient de dilatation est proche de $14 \times 10^{-6}(°C)^{-1}$. Or, la température d'utilisation des circuits imprimés varie fréquemment de - 55°C à + 125°C. Traditionnellement, les circuits imprimés supportent des composants qui sont fixés par leurs pattes. Ces dernières, par déformation, absorberont la différence de dilatation. Or, les développements de l'électronique imposent une densité toujours croissante de composants à fixer sur le circuit imprimé. C'est pourquoi, on utilise de plus en plus la soudure à plat sur le circuit imprimé. Lorsque ce sont des boîtiers de circuits intégrés en matériau polymère qui sont fixés de cette façon, ils peuvent se dilater de la même manière que le circuit imprimé lors d'écarts de température, et aucune contrainte ne naît. Par contre, lorsqu'ils sont en céramique, matériau utilisé essentiellement pour son étanchéité, le coefficient de dilatation est proche de $5 \times 10^{-6} (°C)^{-1}$. Or, avec un composant en céramique relativement long (par exemple 2 cm de long) et de coefficient de dilatation de $5 .10^{-6}(°C)^{-1}$, une baisse de température de + 125°C à 55°C n'entraîne une contraction que de 8,4 μ, alors que le support en matériau organique tel que fibre de verre résine époxyde ou fibre de verre polyimide, se contractera de 19,6 μ, provoquant une différence de dilatation de 11,2 μ, ce qui est largement suffisant pour provoquer des contraintes et des fissurations dans les soudures en alliage étain - plomb joignant les extrémités des composants à leurs points de connection sur le circuit imprimé. Ainsi, lors des différents cycles thermiques, les joints de soudure subissent de fortes contraintes mécaniques pouvant entraîner la rupture de ces soudures.

On a alors pensé à modifier la nature du support lui-même en choisissant des matériaux dont le coefficient de dilatation est proche du coefficient de dilatation de la céramique. Mais un tel changement de matériau entraîne de nombreux autres inconvénients. Par exemple, un support du type Epoxy-Kevlar (Kevlar : dénomination commerciale de la société Du Pont de Nemours) présente un ramollissement et une modification physique à une température de + 125° C. De plus, la conductivité thermique d'un tel support est très faible, c'est-à-dire que la chaleur dégagée par les circuits intégrés n'est pas évacuée. Enfin, un tel support en résine se fissure facilement, ce qui peut entraîner des défauts.

Un support en fibre de quartz et résine époxyde (ou polyimide) est très difficile à usiner et à percer, si bien que la réalisation d'un tel circuit imprimé avec un tel support est très coûteuse.

Un support Kevlar-polyimide présente également une conductivité très faible. De plus, il absorbe fortement l'humidité. Un haut pourcentage de cassures apparaît généralement lors de la fabrication.

On a aussi pensé à utiliser un support conventionnel renforcé par une âme métallique du type cuivre-invar-cuivre, mais cette solution présente un poids excessivement élevé. Aucune solution n'est donc satisfaisante lorsqu'on veut prendre en compte l'ensemble de tous ces facteurs.

On a alors pensé à revêtir un support conventionnel, c'est-à-dire en fibre de verre - résine époxyde ou en fibre de verre - polyimide, d'une couche élastomère déformable en polymère. Mais une telle réalisation présente l'inconvénient que la couche conductrice se dilate, non seulement dans le plan du circuit imprimé, mais également perpendiculairement au plan du circuit imprimé, ce qui influence la tenue des liaisons entre couches et entraîne une rupture des métallisations situées dans les trous métallisés des circuits imprimés et destinées à assurer la liaison entre chaque face des circuits imprimés.

Les problèmes se posent également de manière identique, actuellement, par exemple sur des passages isolants verre-métal. En effet, on adapte les coefficients de dilatation des différents matériaux. Cependant, si, par la suite, ces dispositifs subissent une déformation d'ensemble liée à l'hétérogénéité des modules d'élasticité des matériaux, une rupture ou une décohésion au niveau de l'interface naîtra, du fait des contraintes mécaniques.

La présente invention a pour but de pallier ces inconvénients.

Elle a, en effet, pour objet un élément de compensation de contraintes d'origine thermique et/ou mécanique dans un corps solide constitué de différents matériaux, dues, soit à la différence des coefficients de dilatation desdits matériaux, soit à la différence de leurs modules d'élasticité, élément caractérisé en ce qu'il est constitué partiellement ou complètement d'un alliage pseudoélastique ou à mémoire de forme subissant de façon réversible des déformations importantes, même sous de très faibles contraintes.

L'invention sera mieux comprise grâce à la description ci-après d'un premier mode de réalisation préféré, donné à titre d'exemple non limitatif, d'un circuit imprimé, dont la couche conductrice de base de son support est constituée par un tel élément de compensation.

Conformément à l'invention, l'élément de compensation est constitué complètement d'un alliage pseudoélastique ou à mémoire de forme subissant de façon réversible des déformations importantes, même sous de très faibles contraintes et forme la couche conductrice de base du support d'un circuit imprimé, permettant ainsi de limiter les contraintes d'origine thermique résultant de la différence entre les coefficients de dilatation des boîtiers des circuits intégrés supportés par le circuit imprimé, d'une part, et du support du circuit imprimé, d'autre part, grâce à une transformation martensitique dans un intervalle de température correspondant au domaine de cyclage thermique.

Ainsi cette couche conductrice ne peut subir de façon réversible des déformations importantes que dans deux dimensions, c'est-à-dire dans le plan du circuit imprimé.

La couche est, en outre, composée de polycristaux à très gros grains afin de permettre une plus grande déformation. En effet, pour assurer la réversibilité, le front de transformation martensitique doit pouvoir se déplacer sans obstacle. La grandeur des grains est supérieure ou égale à environ 3 mm.

Cette couche remplace la couche habituelle de cuivre ainsi que celle de polymère. Elle doit, par conséquent, être conductrice et contient à cet effet au moins 50 % de teneur en cuivre, préférentiellement 60 % à 80 %.

Le choix des autres constituants de la couche conductrice est notamment déterminé par le choix de la température de début de transformation martensitique $M_S$. Mais un certain nombre d'autres critères interviendront également, tels l'aptitude à recevoir un dépôt de cuivre, la soudabilité à l'alliage étain - plomb, ou encore, les possibilités de mise en forme, par exemple, par laminage à chaud ou à froid dans le domaine biphasé avec recuits intermédiaires.

Selon une variante de l'invention, la couche conductrice pourra être en un alliage pseudoélastique ou à mémoire de forme Cu Zn Al. Avec une telle composition, on peut situer l'intervalle de température où se produit la transformation martensitique entre les températures extrêmes du cycle, à savoir de - 55°C à + 125° C. A titre d'exemple, la composition sera de 73,5 % en poids de Cu, 20,5 % en poids de Zn et 6 % en poids d'Al pour une température de début de transformation martensitique $M_S$ de 60°C. Pour une température $M_S$ de - 10°C, ces pourcentages seront de 74,42 % en poids de Cu, 18,45 % en poids de Zn et de 7,13 % en poids d'Al.

Selon une autre variante de l'invention, la couche conductrice pourra être en un alliage pseudoélastique ou à mémoire de forme Cu Zn Sn. Elle pourra etre composée plus généralement des alliages suivants : Cu Zn, Cu Zn Ni, Cu Zn Ag, Cu Zn Au, Cu Zn Cd, Cu Zn Ga, Cu Zn In, Cu Zn Ge, Cu Zn Sb, Cu Zn Si, Cu Sn, Cu Al Ni, Cu Al, Cu Zn Al Ni, et plus généralement encore de tous les alliages conducteurs pseudoélastiques ou à mémoire de forme. L'épaisseur de la couche conductrice est comprise entre 30 μ et 200 μ, avantageusement 100 μ.

L'invention a également pour objet un procédé de fabrication d'un circuit imprimé comportant un élément de compensation conforme à l'invention, qui consiste à préparer des feuilles minces polycristallines en un matériau conducteur pseudoélastique ou à mémoire de forme, puis à assembler par tous moyens connus ces feuilles formant la couche conductrice sur la face supérieure et/ou inférieure du support du circuit imprimé.

A titre d'exemple, la couche conductrice pourra être collée sur la face supérieure et/ou inférieure du support du circuit imprimé.

Ainsi, la forte déformation réversible acceptée par les matériaux pseudoélastiques ou à mémoire de forme composant la couche conductrice permettra de limiter considérablement les contraintes d'origine thermique responsables des ruptures au niveau des soudures.

L'élément de compensation objet de l'invention permet, en outre, une évacuation meilleure de la charge thermique, présente l'avantage d'être léger, et ne nécessite aucune modification importante dans les chaînes de fabrication.

L'invention a, en outre, aussi pour objet un procédé de fabrication d'un boîtier de composant électronique comportant un élément de compensation conforme à l'invention, utilisant un alliage identique à la couche conductrice telle que définie dans l'invention, qui consiste à préparer des éléments de connexion vers l'extérieur en un matériau pseudoélastique ou à mémoire de forme, puis à assembler par tous moyens connus ces éléments de connexion sur le boîtier de composant électronique de façon à assurer une liaison électrique et mécanique entre le composant électronique et le circuit imprimé.

Selon un second mode de réalisation et conformément à l'invention, l'élément de compensation constitue l'interface d'un passage verre-métal, permettant ainsi de limiter les contraintes d'origine mécanique résultant de la différence des modules d'élasticité du verre, d'une part, et du métal, d'autre part. Ainsi, une couche d'un matériau pseudoélastique ou à mémoire de forme disposée entre le verre et le métal, par exemple, par collage, permet de limiter considérablement les contraintes d'origine mécanique responsables des ruptures ou décohésion au niveau de l'interface.

Bien entendu, l'invention n'est pas limitée aux modes de réalisation décrits. Des modifications restent possibles, notamment du point de vue de la constitution des divers éléments, ou par substitution d'équivalents techniques, sans sortir pour autant du domaine de protection de l'invention.

## Revendications

1. Elément de compensation de contraintes d'origine thermique et/ou mécanique dans un corps solide constitué de différents matériaux, dues, soit à la différence des coefficients de dilatation desdits matériaux, soit à la différence de leurs modules d'élasticité, élément caractérisé en ce qu'il est constitué partiellement ou complètement d'un alliage pseudoélastique ou à mémoire de forme subissant de façon réversible des déformations importantes, même sous de très faibles contraintes.

2. Circuit imprimé, caractérisé en ce que la couche conductrice de base de son support est constituée par un élément de compensation selon la revendication 1, permettant ainsi de limiter les contraintes d'origine thermique résultant de la différence entre les coefficients de dilatation des boîtiers des circuits intégrés supportés par le circuit imprimé, d'une part, et du support de circuit imprimé, d'autre part, grâce à une transformation martensitique dans un intervalle de température correspondant au domaine de cyclage thermique.

3. Circuit imprimé selon la revendication 2, caractérisé en ce que la couche conductrice est composée de polycristaux à très gros grains afin d'obtenir une plus grande déformation.

4. Circuit imprimé selon la revendication 3, caractérisé en ce que la grandeur des grains est supérieure ou égale à environ 3 mm.

5. Circuit imprimé selon l'une quelconque des revendications 2 à 4, caractérisé en ce que la couche conductrice est en un alliage à au moins 50 % de teneur en cuivre.

6. Circuit imprimé selon la revendication 5, caractérisé en ce que la teneur en cuivre est préférentiellement de 60 % à 80 %.

7. Circuit imprimé selon l'une quelconque des revendications 5 et 6, caractérisé en ce que le choix des autres constituants de la couche conductrice est notamment déterminé par le choix de la température de début de transformation martensitique $M_S$.

8. Circuit imprimé selon l'une quelconque des revendications 5 à 7, caractérisé en ce que la couche conductrice est en alliage pseudoélastique ou à mémoire de forme Cu Zn Al.

9. Circuit imprimé selon l'une quelconque des revendications 5 à 7, caractérisé en ce que la couche conductrice est en alliage pseudoélastique ou à mémoire de forme Cu Zn Sn.

10. Circuit imprimé selon l'une quelconque des revendications 5 à 7, caractérisé en ce que la couche conductrice est en un des alliages pseudoélastiques ou à mémoire de forme suivants Cu Zn, Cu Zn Ni, Cu Zn Ag, Cu Zn Au, Cu Zn Cd, Cu Zn Ga, Cu Zn In, Cu Zn Ge, Cu Zn Sb, Cu Zn Si, Cu Sn, Cu Al Ni, Cu Al et Cu Zn Al Ni.

11. Circuit imprimé selon l'une quelconque des revendications 2 à 10, caractérisé en ce que l'épaisseur de la couche conductrice est comprise entre 30 $\mu$ et 200 $\mu$.

12. Circuit imprimé selon la revendication 11, caractérisé en ce que l'épaisseur de la couche conductrice est préférentiellement de 100 $\mu$.

13. Passage verre-métal, caractérisé en ce que son interface est constituée par un élément de compensation selon la revendication 1, permettant ainsi de limiter les contraintes d'origine mécanique résultant de la différence des modules d'élasticité du verre, d'une part, et du métal, d'autre part.

14. Procédé de fabrication d'un circuit imprimé selon l'une quelconque des revendications 2 à 12, comportant un élément de compensation selon la revendication 1, caractérisé en ce qu'il consiste à préparer des feuilles minces polycristallines en un matériau conducteur pseudoélastique ou à mémoire de forme, puis à assembler par tous moyens connus ces feuilles formant la couche conductrice sur la face supérieure et/ou inférieure du support du circuit imprimé.

15. Procédé de fabrication selon la revendication 14, caractérisé en ce que l'assemblage de la couche conductrice sur la face supérieure et/ou inférieure du support du circuit imprimé est effectué par collage.

16. Procédé de fabrication d'un boîtier de composant électronique comportant un élément de compensation selon la revendication 1, utilisant un alliage identique à la couche conductrice telle que définie selon l'une quelconque des revendications 2 à 10, caractérisé en ce qu'il consiste à préparer des éléments de connexion vers l'extérieur en un matériau pseudoélastique ou à mémoire de forme, puis à assembler par tous moyens connus ces éléments de connexion sur le boîtier de composant électronique de façon à assurer une liaison électrique et mécanique entre le composant électronique et le circuit imprimé.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-3 594 895 (J. RUSSEL et al.) * Colonne 2, ligne 11 - colonne 3, ligne 11 * | 1 | H 05 K 1/09 C 22 F 1/00 C 04 B 37/02 C 03 C 27/04 |
| A | | 13 | |
| A | JOURNAL OF METALS, vol. 32, no. 6, juin 1980, pages 129-136, New York, US; C.M. WAYMAN: " Some applications of shape-memory alloys" | | |
| A | US-A-3 599 316 (CONTINENTAL CAN CO. INC.) | | |
| A | ELECTRONICS, vol. 56, no. 5, 10 mars 1983, pages 48-49, new York, US: J. LYMAN: "Chip-carrier TCE finds its match" | | |

DOMAINES TECHNIQUES
RECHERCHES (Int. Cl.4)

H 05 K
C 22 F
C 04 B
C 03 C
H 01 L

Le présent rapport a été établi pour toutes les revendications

| Lieu de la recherche | Date d'achèvement de la recherche | Examinateur |
|---|---|---|
| LA HAYE | 03-02-1988 | SCHUERMANS N.F.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P0402)